# EUROPEAN PATENT APPLICATION

(11) **EP 3 606 305 A1**
(43) Date of publication of application: **05.02.2020**
(21) Application number: 18770399.6
(22) Date of filing: 16.03.2018
(51) Int. Cl.: H05K 7/20, H01L 23/367, H01L 23/40, H02M 7/00

(54) **HEAT DISSIPATING DEVICE FOR POWER CONVERTING MODULE, AND POWER CONVERTING MODULE COMPRISING SAME**

(30) Priority: 20.03.2017 KR 20170034864
(71) Applicant: LG Innotek Co., Ltd., Seoul 04637 (KR)
(72) Inventor: SONG, Young Kil, Seoul 04637 (KR)
(74) Representative: Zardi, Marco
(86) International application number: PCT/KR2018/003069
(87) International publication number: WO 2018/174470

(57) **Abstract**

A heat dissipating device for a power converting module, according to an embodiment, comprises: a housing; a substrate disposed in the housing; a heating element which is disposed in the housing and is connected to the substrate; a first heat dissipating plate which is disposed in the housing and is coupled to the heating element; and a second heat dissipating plate disposed below the first heat dissipating plate, wherein the heating element is coupled to the side surface of the first heat dissipating plate, and the first heat dissipating plate is disposed between the substrate and the second heat dissipating plate.

## Description

### [Technical Field]

The present invention relates to a heat dissipating device for a power converting module, and a power converting module including the same.

### [Background Art]

Generally, in a power converting module, a heat dissipation design is prioritized for a heat dissipating device due to a significant influence on the reliability of a power converting module. In addition, in order to improve a heat dissipation effect, a circuit structure for minimizing power loss, an effective attachment structure of heating element, a structure and material of a heat dissipating fin and a case, a dissimilar component such as thermal grease, bonding materials of materials, molding materials, etc. are important considerations. High efficiency heat dissipation performance of the power converting module may be ensured by optimizing the considerations.

More specifically, the power converting module according to the related art cools using a forced air cooling or water cooling method in consideration of a heat generation amount of an element. The forced air cooling method has a problem that the heat transfer capability is lowered although it is cheaper than the water cooling method in terms of cost. As an example, in the case of an on-substrate charger with a 3.3 KW output capacity, forced air cooling and water cooling methods are used simultaneously.

In addition, in case of the forced air cooling, a method of cooling by using a charger case as a heat radiator is used rather than simply cooling a high heating element using a heat sink. Such a heat dissipating device cools the entire system by blowing external air to a heat dissipating case using an external fan for sufficient cooling, and at this point, the heating element is designed to minimize thermal resistance by bonding it as close to the heat dissipating case as possible.

Further, in case of a DC-DC converter, fan air is blown directly onto fins of a heat sink case in which an element is mounted by the conventional cooling method to minimize heat concentration of the element. Hereinafter, a heat dissipating device of a power converting module according to the related art will be described.

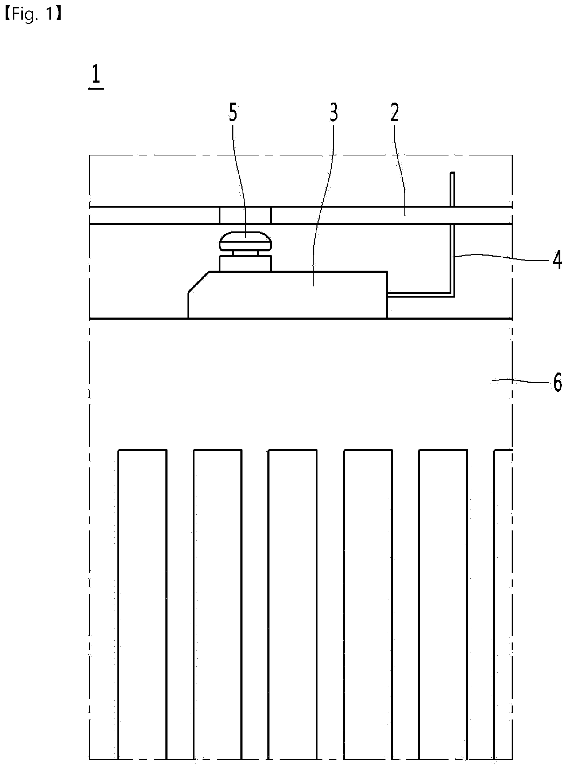

FIG. 1 is a view showing a heat dissipating device of a power converting module according to the related art.

Referring to FIG. 1, a heat dissipating device 1 of the power converting module includes a substrate 2 disposed inside a case (not shown), a heating element 3 including a terminal 4 connected to the substrate 2, a heat dissipating plate 6 coupled to the heating element 3, and a fixing member 5 for fixing the heating element 3 to the heat dissipating plate 6.

In the heat dissipating device 1 as described above, the heating element 3 and the heat dissipating plate 6 are in direct contact with each other, and thus heat generated in the heating element 3 is transferred to the heat dissipating plate 6. Further, a heat dissipating fin of the heat dissipating plate 6 is exposed to the outside of the case, and accordingly, the heat transferred through the heating element 3 is released to the outside.

However, in the heat dissipating device, since the heat of the heating element 3 is immediately transferred to the heat dissipating plate 6, a temperature of the heat dissipating plate 6 itself is high, and thus there is a danger in an environment in which human contact with the heat dissipating plate 6 exposed to the outside may occur.

In addition, since the heating element 3 should be in direct contact with the heat dissipating plate 6 in the heat dissipating device, a component arrangement area of the heating element 3 is increased, and thus there is a problem that a substrate area increases and an overall size increases as the component arrangement area increases.

Further, in the heat dissipating device, when applying a plurality of heat dissipating components, each heat dissipating component should be individually assembled on the substrate, and when the heat dissipating component is fastened with a fastening member such as a screw, a problem of a separation distance occurs.

### [Disclosure]

### [Technical Problem]

An embodiment according to the present invention provides a heat dissipating device for a power converting module capable of transferring heat to a main heat dissipating plate after heat transferred from a heating element is primarily dissipated by applying a separate sub-heat dissipating plate at the sub-heat dissipating plate.

In addition, an embodiment according to the present invention provides a heat dissipating device for a power converting module that may assemble a plurality of heat dissipating components modularly.

Technical objects to be solved by the proposed embodiments are not limited to the above-mentioned technical objects, and other unmentioned technical objects may be clearly understood by those skilled in the art to which the embodiments proposed from the following descriptions belong.

### [Technical Solution]

A heat dissipating device of a power converting module according to an embodiment includes: a housing; a substrate disposed inside the housing; a heating element disposed inside the housing and connected to the substrate; a first heat dissipating plate disposed inside the housing and coupled to the heating element; and a second heat dissipating plate disposed at a lower portion of the first heat dissipating plate, wherein the heating element is coupled to a side surface of the first heat dissipating plate, the first heat dissipating plate is disposed between the substrate and the second heat dissipating plate.

The side surface of the first heat dissipating plate to which the heating element is coupled is perpendicular to the substrate.

The heating element is vertically disposed at a lower portion of the substrate to be coupled to the side surface of the first heat dissipating plate.

The heating element includes a fastening hole, and the first heat dissipating plate includes a first fastening groove, and further includes a fastening member that passes through the fastening hole to be inserted into the first fastening groove.

The heat dissipating device of a power converting module further includes a spacer disposed between the first heat dissipating plate and the substrate.

The heat dissipating device of a power converting module further includes a support member that is coupled to the first heat dissipating plate to support the heating element.

The support member includes a first support region that is coupled to the first heat dissipating plate and includes a through-hole, a second support region that is bent in a first direction from the first region, and a third support region bent from the second region in a second direction opposite to the first direction and contacts the heating element.

The third region of the support member has a predetermined curvature at a portion in contact with the heating element.

The third support region includes a plurality of branch portions spaced apart from the second support region at a predetermined distance.

The heating element includes at least one first heating element disposed on a first side surface of the first heat dissipating plate and at least one second heating element disposed on a second side surface of the first heat dissipating plate.

The second heat dissipating plate includes a base disposed on a lower surface of the first heat dissipating plate, and a heat dissipating fin protruding from the base and partially exposed to the outside of the housing.

At least one placing portion formed in a region in which the first heat dissipating plate is disposed to be divided from other regions is formed on an upper surface of the base.

The first heat dissipating plate includes a first heat dissipating portion coupled to the second heat dissipating plate, a second heat dissipating portion protruding upward from an upper surface of the first heat dissipating portion, and in which the heating element is coupled to a side surface thereof, and the first heat dissipating portion has a width larger than that of the second heat dissipating portion.

The heat dissipating device of a power converting module further includes at least one boss disposed in an edge region of the base of the second heat dissipating plate and supporting the substrate, wherein the substrate has a boss through-hole formed in a region in contact with the boss.

### [Advantageous Effects]

According to an embodiment of the present invention, heat transferred via a heating element is primarily dissipated by using a separate sub-heat dissipating plate, and the heat dissipated primarily is transferred to a main heat dissipating plate to be released to the outside, and thus heat transferred to the main heat dissipating plate may be minimized. Accordingly, it is possible to solve safety problems that may occur as a temperature of the main heat dissipating plate exposed to the outside increases.

In addition, according to an embodiment of the present invention, an area occupied by the heating element on the substrate may be reduced by mounting the heating element vertically on the substrate, and accordingly the overall size of a power converting module may be reduced.

In addition, according to an embodiment of the present invention, assembly processes of a plurality of heat dissipating components may be simplified by manufacturing and assembling the plurality of heat dissipating components in a modular type, and accordingly an arrangement space for heat dissipating components may be optimized.

### [Description of Drawings]

FIG. 1 is a view showing a heat dissipating device of a power converting module according to the related art.
FIG. 2 is a view showing a power converting module according to an embodiment of the present invention.
FIG. 3 is an exploded perspective view of the power converting module 100 shown in FIG. 2.
FIG. 4 is a view showing the upper case shown in FIG. 3.
FIGS. 5 to 7 are views specifically showing the lower case and the second heat dissipating plate shown in FIG. 3.
FIG. 8 is a view specifically showing the circuit breaker module unit 400 shown in FIG. 3.
FIG. 9 is a view specifically showing the battery management module unit 500 shown in FIG. 3.
FIG. 10 is a view specifically showing the power converting module unit 600 shown in FIG. 3.
FIG. 11 is a view specifically showing a heat dissipating module 650 shown in FIG. 10.
FIG. 12 is a view specifically showing a support member 656 of FIG. 11.
FIG. 13 is a flowchart step by step showing a method of manufacturing the heat dissipating module 650 shown in FIG. 11.
FIGS.14 to 18 are views showing in process sequence a method of manufacturing the heat dissipating module 650 according to an embodiment of the present invention.
FIG. 19 is a view for describing a heat dissipation mechanism according to an embodiment of the present invention

### [Modes of the Invention]

Advantages, features, and methods of achieving the same of the present disclosure will become clear upon referring to embodiments described below in detail with reference to the accompanying drawings. However, the present disclosure is not limited to the embodiments disclosed below and may be implemented in various other forms. The embodiments are merely provided to make the disclosure of the present disclosure complete and completely inform one of ordinary skill in the art to which the present disclosure pertains of the scope of the present disclosure. The present disclosure is defined only by the scope of the claims below. Like reference numerals refer to like elements throughout.

In describing embodiments of the present disclosure, when detailed description of a known function or configuration is deemed to unnecessarily blur the gist of the present disclosure, the detailed description will be omitted. Terms described below are terms defined in consideration of functions in the embodiments of the present disclosure and may vary depending on the intention of a user or operator or a practice. Therefore, such terms should be defined on the basis of the entire contents disclosed herein.

Combinations of blocks and steps of flowcharts in the accompanying drawings can be performed by computer program instructions. Such computer program instructions can be embedded in a processor of a general-purpose computer, a special-purpose computer, or other programmable data processing equipment. Therefore, the instructions performed by the processor of other programmable data processing equipment generate means for performing functions described in each of the blocks or each of the steps in the flowcharts in the drawings. Therefore, the instructions performed by the processor of other programmable data processing equipment generate means for performing functions described in each of the blocks or each of the steps in the flowcharts in the drawings. Because the computer program instructions can also be saved in a computer-usable or computer-readable memory capable of supporting a computer or other programmable data processing equipment to implement a function in a specific way, the instructions stored in the computer-usable or computer-readable memory can also produce a manufacturing item which incorporates an instruction means performing a function described in each of the blocks or each of the steps of the flowcharts in the drawings. Because the computer program instructions can also be embedded in a computer or other programmable data processing equipment, the instructions performed in a computer or other programmable data processing equipment by a process executed in a computer being generated by a series of operation steps being performed in the computer or other programmable data processing equipment can also provide steps for executing functions described in each of the blocks and each of the steps of the flowcharts in the drawings.

Each of the blocks or each of the steps may represent a module, a segment, or a part of a code including one or more executable instructions for executing a specified logical function(s). Also, it should be noted that functions mentioned in the blocks or steps can also be performed in a different order in a few alternative embodiments. For example, two blocks or steps which are consecutively illustrated can substantially be performed simultaneously, or the blocks or steps can also be performed in a reverse order sometimes according to corresponding functions.

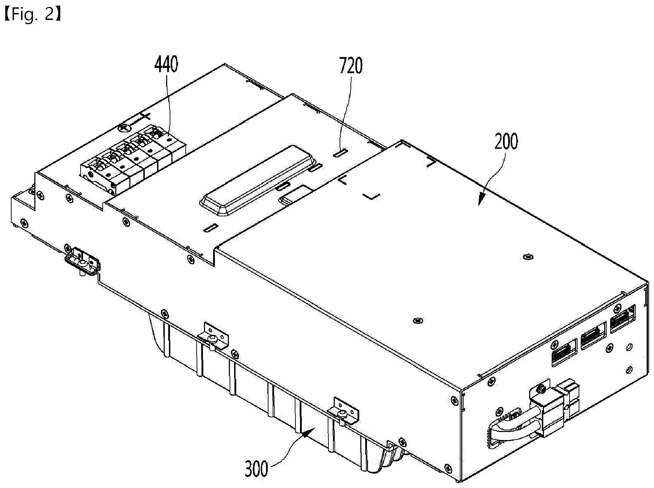

FIG. 2 is a view showing a power converting module according to an embodiment of the present invention.

Referring to FIG. 2, a power converting module 100 includes a housing 200 having an accommodating space therein, a plurality of power module units 400, 500, and 600 accommodated in an inner accommodating space of the housing 200, and a second heat dissipating plate 300 at least a part of which is accommodated in the housing 200 to be coupled to the plurality of power module units 400, 500, and 600 and a remaining part of which is exposed to the outside of the housing 200.

A space in which the power module units 400, 500, and 600 are accommodated may be formed inside the housing 200. In addition, a space in which the second heat dissipating plate 300 is accommodated may be formed inside the housing 200.

The housing 200 protects the power module units 400, 500, and 600 accommodated therein. Preferably, the housing 200 protects the power converting module 100 from various environmental factors (for example, moisture, wind, temperature, etc.) generated in a usage environment of the power converting module 100.

In addition, a plurality of first through-holes 221 that are spaced apart from each other at a predetermined distance are formed at the lower portion of the housing 200.

The first through-hole 221 has a shape extending long in a first direction from the lower surface of the housing 200. Here, the first direction may be a lateral direction connecting a right end from a left end of the lower surface of the housing 200. Further, a plurality of the first through holes 221 may be formed to be spaced a predetermined distance apart from the lower surface of the housing 200 in a second direction. The second direction may be a vertical direction connecting a lower end from an upper end of the lower surface of the housing 200. That is, the second direction may be a direction orthogonal to the first direction.

That is, the first through-hole 221 having a shape extending long in the first direction while being spaced apart at a predetermined distance in the second direction of the lower surface of the housing 220 may be disposed on the lower surface of the housing 200 in plural. The first through-hole 221 has a shape corresponding to a plurality of heat dissipating fins 320 configuring the second heat dissipating plate 300 to be described later.

In addition, at least one of second through-holes 2111, 2121, and 2131 is formed on an upper surface of the housing 200. The second through-holes 2111, 2121, and 2131 are formed in order to expose at least one of configurations accommodated in the accommodating space of the housing 200 to the outside.

That is, a circuit breaker module unit 400 may be included in the power module units 400, 500, and 600 accommodated in the housing 200, and a breaker exposure hole 2121 that exposes a circuit breaker 440 configuring the circuit breaker module unit 400 to the outside may be formed in the upper surface of the housing 200.

In addition, an interface exposure hole 2111 for exposing a signal input/output (IO) port 431 for communication with an external device (not shown) may be further formed at the circuit breaker module unit 400.

Further, a status notification module unit 700 may be further included at the power module units 400, 500, and 600 accommodated in the housing 200, and the status notification module unit 700 may include a light emitting element (not shown). Accordingly, the housing 200 may further include a lens insertion hole 2131 into which a lens 720 diffusing light generated from the light emitting element is inserted while exposing the light emitting element to the outside.

A part of the second heat dissipating plate 300 accommodated in the housing 200 is exposed to the outside through the first through-hole 221 formed in the lower surface of the housing 200. The second heat dissipating plate 300 releases heat generated from the power module units 400, 500, and 600 accommodated inside the housing 200 to the outside of the housing 200.

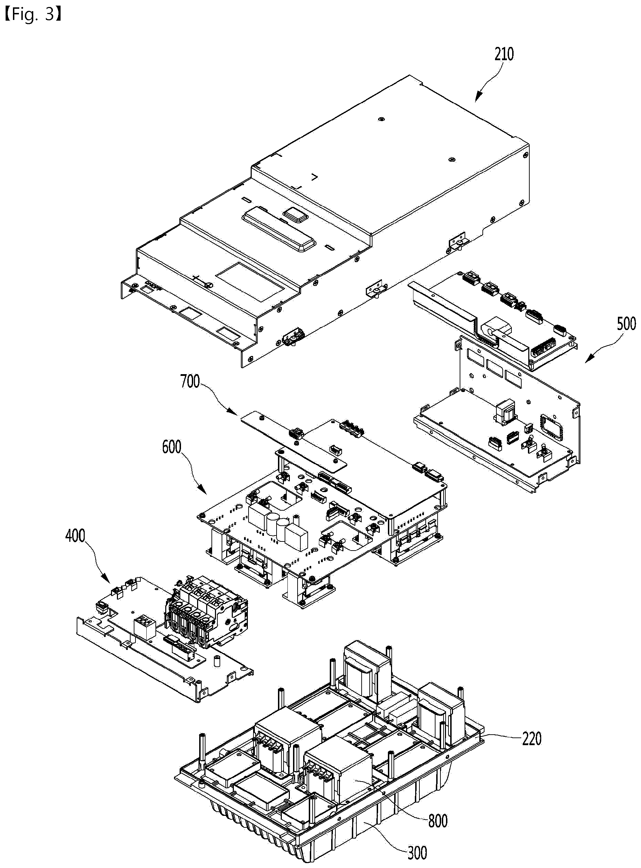

FIG. 3 is an exploded perspective view of the power converting module 100 shown in FIG. 2.

Referring to FIG. 3, the power converting module 100 includes an upper case 210 and a lower case 220 configuring a housing 200, a second heat dissipating plate 300 that is partly accommodated in the housing 200 and a remaining part is exposed to the outside of the housing 200, a circuit breaker module unit 400 disposed in an accommodation space of the housing 200, a battery management module unit 500 disposed in the accommodation space of the housing 200, a power converting module unit 600 disposed in the accommodation space of the housing 200, a status notification module unit 700 disposed in the accommodation space of the housing 200 and having at least one component exposed to the outside of the housing 200, and an electronic component 800 disposed in the accommodation space of the housing 200 and placed on the second heat dissipating plate 300.

The housing 200 includes an upper case 210 and a lower case 220.

The lower case 220 supports a second heat dissipating plate 300 disposed on the lower case 220. That is, the second heat dissipating plate 300 is placed on a bottom surface of the lower case 220. Further, the plurality of first through-holes 221 described above are formed on the bottom surface of the lower case 220, and heat dissipating fins configuring the second heat dissipating plate 300 are exposed to the outside of the lower case 220 through the first through-hole 221.

The upper case 210 is disposed on the lower case 220.

The upper case 210 covers the circuit breaker module unit 400, the battery management module unit 500, the power converting module unit 600, the status notification module unit 700, and the electronic component 800 disposed on the second heat dissipating plate 300. Preferably, an accommodation space in which the power module units are accommodated may be formed in the upper case 210.

An upper surface of the upper case 210 may have a layered structure. Preferably, the upper surface of the upper case 210 may have a staircase shape corresponding to a height of each power module unit accommodated therein.

The second heat dissipating plate 300 is placed on the bottom surface of the lower case 220, and at least a part thereof is exposed to the outside through the first through-hole 221 of the lower case 220.

On the second heat dissipating plate 300, a first heat dissipating plate (described later) and a placing portion (described later) on which the electronic component 800 may be placed are prepared. The placing portion is formed to protrude and have a predetermined height so as to be distinguished from other regions on an upper surface of the second heat dissipating plate 300. In addition, the placing portion is divided from an upper surface of the other region except the placing portion on the second heat dissipating plate 300. Accordingly, the first heat dissipating plate and the electronic component 800 are stably placed on the second heat dissipating plate 300, and further, it is possible to prevent the first heat dissipating plate and the electronic component 800 from moving to another position instead of a position in which the first heat dissipating plate and the electronic component 800 are placed.

The electronic component 800 is placed on the second heat dissipating plate 300. The electronic component 800 is coupled to the second heat dissipating plate 300. At this time, the electronic component 800 may have a predetermined height, and may be placed on the second heat dissipating plate 300. Preferably, the electronic component 800 may be a large scale component having a predetermined height and a size, such as a transformer or an inductor.

The power module units are disposed on the second heat dissipating plate 300.

The power module unit includes the circuit breaker module unit 400, the battery management module unit 500, the power converting module unit 600, and the status notification module unit 700.

At this time, the power converting module unit 600 and the status notification module unit 700 are disposed in an upper region of the second heat dissipating plate 300. In addition, the circuit breaker module unit 400 has one end coupled to a left end of the lower case 220, and the battery management module unit 500 has one end coupled to a right end of the lower case 220.

Accordingly, the circuit breaker module unit 400 and the battery management module unit 500 are not disposed in the upper region of the second heat dissipating plate 300, but are disposed in a region spaced a predetermined distance apart from the upper region leftward or rightward.

Therefore, a width of an upper region of the lower case 220 may be smaller than that of a lower region of the upper case 210. Preferably, the width of the upper region of the lower case 220 may correspond to a width of the power converting module unit 600.

In addition, the power converting module unit 600, the battery management module unit 500, and the circuit breaker module unit 400 may be disposed in the upper region of the lower case 220 in a row in the horizontal direction.

Accordingly, the width of the lower region of the upper case 210 may correspond to the total width of the width of the power converting module unit 600, the width of the battery management module unit 500, and the width of the circuit breaker module unit 400.

The circuit breaker module unit 400 includes a circuit breaker 440, and thus an operation of the power converting module 100 may be on and off.

The battery management module unit 500 receives battery power supplied via a battery (not shown), and transmits the received battery power to the power converting module unit 600. Preferably, the battery management module unit 500 controls the battery power supplied via the battery to supply the power to the power converting module unit 600.

The power converting module unit 600 uses the battery power supplied via the battery management module unit 500 as input power, and converts the input power to generate output power. The power converting module unit 600 may be a DC-DC converter.

The status notification module unit 700 includes at least one light emitting element (not shown), and thus notifies to the outside an overall operation state of the power converting module through blinking of the light emitting element. Preferably, the status notification module unit 700 may display on/off state information of the power converting module or abnormal state information for notifying whether there is device abnormality.

Hereinafter, each component configuring the power converting module 100 will be described more specifically.

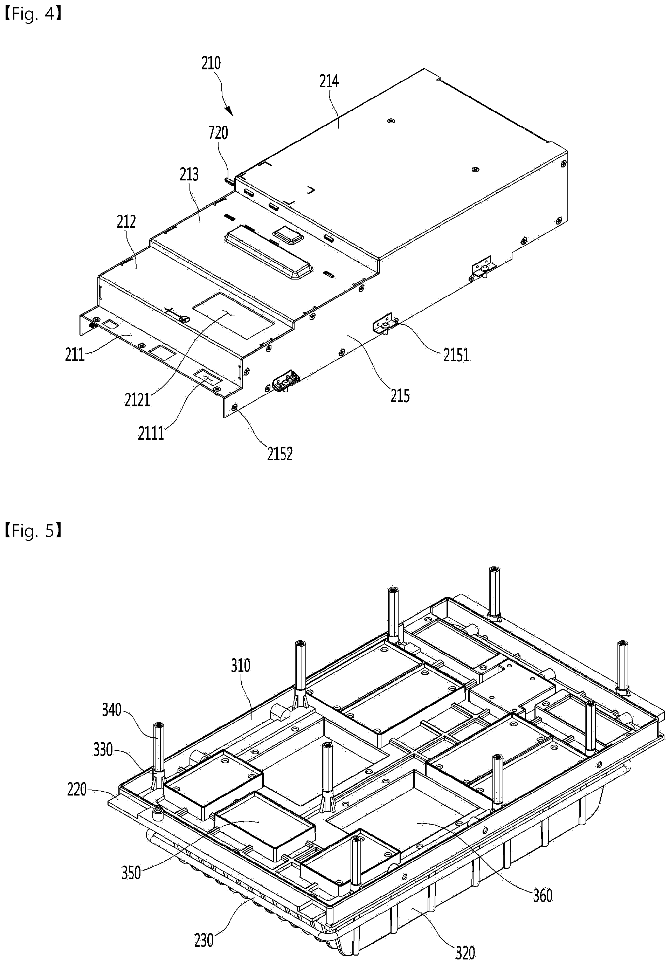

FIG. 4 is a view showing the upper case shown in FIG. 3.

Referring to FIG. 4, the upper case 210 is a frame that covers an upper region and a side region of the circuit breaker module unit 400, the battery management module unit 500, the power converting module unit 600, and the status notification module unit 700 accommodated therein.

The upper case 210 includes upper plate parts 211, 212, 213, and 214 and a side plate part 215 that extends approximately vertically downward from one end of the upper plate parts 211, 212, 213, and 214.

The upper plate parts 211, 212, 213, and 214 have a layered structure. In other words, the upper plate parts 211, 212, 213, and 214 may include a first upper plate 211, a second upper plate 212, a third upper plate 213, and a fourth upper plate 214.

In addition, heights of the first upper plate 211, the second upper plate 212, the third upper plate 213, and the fourth upper plate 214 are different from each other, and accordingly the upper plate parts 211, 212, 213, and 214 of the upper case 210 may have a staircase structure.

The first upper plate 211 has a height corresponding to the signal IO port 431 of the circuit breaker module unit 400 accommodated therein. The first upper plate 211 includes at least one interface exposure hole 2111 that exposes a terminal (not shown) of the signal IO port 431.

The second upper plate 212 has a height corresponding to the circuit breaker 440 of the circuit breaker module unit 400 accommodated therein. The second upper plate 212 includes at least one breaker exposure hole 2121 that exposes a cutoff switch (not shown) of the circuit breaker 440.

The third upper plate 213 has a height corresponding to a first region of the power converting module unit 600 accommodated therein. The power converting module unit 600 includes the first region in which only a power conversion component is disposed and a second region in which a power supply control component is additionally disposed on the power conversion component. In addition, a height of the first region and a height of the second region are different from each other. Accordingly, the third upper plate 213 has a height corresponding to the first region of the power converting module unit 600.

Then, a lens insertion exposure hole 2131 is formed in the third upper plate 213 in order to insert a lens 720 diffusing light generated through a light emitting element, while protecting the light emitting element (not shown) mounted to the status notification module unit 700 accommodated therein.

The fourth upper plate 214 has a height corresponding to the second region of the power converting module unit 600 accommodated therein and the battery management module unit 500.

Accordingly, the signal IO port 431 configuring the circuit breaker module unit 400 is disposed at a lower portion of the first upper plate 211 of the upper case 210.

In addition, the circuit breaker 440 configuring the circuit breaker module unit 400 is disposed at a lower portion of the second upper plate 212 of the upper case 210.

Further, the first region of the power converting module unit 600 and the status notification module unit 700 are disposed at a lower portion of the third upper plate 213 of the upper case 210.

Furthermore, the second region of the power converting module unit 600 and the battery management module unit 500 are disposed at a lower portion of the fourth upper plate 214 of the upper case 210.

Left and right side surfaces of the upper case 210 are opened. Accordingly, the left side surface of the upper case 210 may be covered with a frame of the circuit breaker module unit 400 accommodated therein. Further, the right side surface of the upper case 210 may be covered with a frame of the battery management module unit 500 accommodated therein.

The side plate 215 of the upper case 210 is respectively disposed on front and rear surfaces of the upper plate parts 211, 212, 213, and 214 with reference to the upper plate parts 211, 212, 213, and 214. Accordingly, the upper case 210 may include a front side plate and a rear side plate extending approximately vertically from the upper plate parts 211, 212, 213, and 214.

That is, the front or rear side plate 215 of the upper case 210 is formed to extend approximately vertically downward from one end of the upper plate parts 211, 212, 213, and 214. Accordingly, a height of the side plate 215 may be gradually increased as it goes in the length direction.

In addition, a case coupling portion 2151 for coupling to the lower case 220 is disposed on the side plate 215 of the upper case 21. The lower case 220 is formed with an additional coupling portion (not shown) coupled to the case coupling portion 2151, and a coupling member (for example, a screw) may be fastened to the case coupling portion to fix the upper case 210 on the lower case 220.

Further, a coupling hole 2152 may be further formed in the side plate 215 of the upper case 210 in order to connect to the battery management module unit 500, the power converting module unit 600, and the circuit breaker module unit 400 accommodated therein.

The upper case 210 as described above may be formed of a metal such as aluminum (Al) for blocking electromagnetic waves generated from the power module unit accommodated therein while having high thermal conductivity.

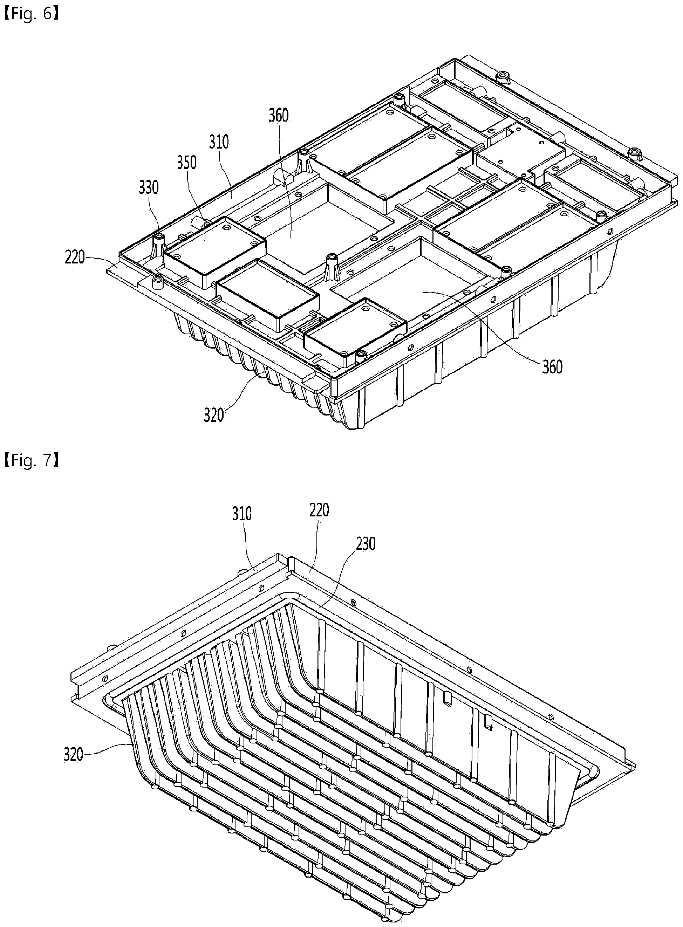

FIGS. 5 to 7 are views specifically showing the lower case and the second heat dissipating plate shown in FIG. 3.

Hereinafter, the lower case 220 and the second heat dissipating plate 300 will be described in more detail with reference to FIGS. 5 to 7.

The lower case 220 couples to the upper case 210 to form the accommodation space. The lower case 220 provides a placing space in which the second heat dissipating plate 300 may be placed. To this end, the lower case 220 includes a lower plate and a protrusion extending upward from an end of the lower plate. That is, the lower case 220 may be formed with a rectangular plate portion provided in the lower portion, and four wall portions extending upward from an end portion of an edge of the plate portion.

Then, a base 310 of the second heat dissipating plate 300 is placed on the lower plate of the lower case 220.

At this time, a plurality of first through-holes 221 that are spaced apart from each other at a predetermined distance are formed in the lower plate of the lower case 220. The first through-hole 221 has a shape extending long in a first direction from one end of the lower plate. Here, the first direction may be a lateral direction connecting a right end to a left end of the lower plate. Further, a plurality of the first through-holes 221 may be formed to be spaced a predetermined distance apart from the lower plate in a second direction. The second direction may be a vertical direction connecting a lower end to an upper end of the lower plate. That is, the second direction may be a direction orthogonal to the first direction.

The first through-hole 221 having a shape extending long in the first direction while being spaced apart at a predetermined distance in the second direction may be disposed in the lower plate in plural. The first through-hole 221 has a shape corresponding to a plurality of heat dissipating fins 320 configuring the second heat dissipating plate 300. In other words, the heat dissipating fin 320 extends long in the vertical direction at a lower surface of the base 310, and the first through-hole 221 is an insertion hole into which the heat dissipating fin 320 is inserted.

The second heat dissipating plate 300 is disposed on the lower plate of the lower case 220. Preferably, the base 310 of the second heat dissipating plate 300 is disposed on the lower plate of the lower case 220, and the heat dissipating fin 320 of the second heat dissipating plate 300 is exposed to the outside of the lower case 220 through the first through-hole 221.

The base 310 of the second heat dissipating plate 300 has a plate shape, and is provided with placing portions 350 and 360 divided into a plurality of regions on an upper surface thereof. The placing portions 350 and 360 include a first placing portion 350 on which a first heat dissipating plate 651 configuring a heat dissipating module is placed and a second placing portion 360 on which the electronic component 800 is placed.

At this time, the first placing portion 350 is disposed higher than other regions of the upper surface of the base 310. The second placing portion 360 is disposed lower than other regions of the upper surface of the base 310. That is, the large scale electronic component 800 is placed on the second placing portion 360, and thus the overall module volume increases due to a height of the electronic component 800. Therefore, the second placing portion 360 has a recessed shape recessed inside compared with other regions, so that the overall height of the module is decreased by the recessed depth. Further, the first heat dissipating plate 651 is disposed on the first placing portion 350. At this time, a height of the first heat dissipating plate 651 may be lower than that of the electronic component 800, and thus a substrate and the electronic component 800 configuring the power converting module unit 600 may contact each other. Accordingly, the first placing portion 350 protrudes from the upper surface of the base 310 at a predetermined height such that the substrate of the power converting module unit 600 and the electronic component 800 do not contact each other.

Then, a stepped portion protruding upward is formed in an edge region of the first placing portion 350, and the first heat dissipating plate 651 is sandwiched in the stepped portion such that the first heat dissipating plate 651 may be placed on the first placing portion 350. In addition, a fastening hole into which a fastening member (not shown) for fastening with the first heat dissipating plate 651 is inserted may be further formed in the first placing portion 350.

In addition, a boss fastening portion 330 is disposed in an edge region of the base 310 of the second heat dissipating plate 300 or an edge region of the lower case 220. The boss fastening portion 330 may be a fastening hole for fastening a boss 340 for supporting and fixing the power converting module unit 600 disposed on the lower case 220 and the second heat dissipating plate 300.

The boss 340 has a predetermined height and protrudes in an upper direction of the lower case 220 and the second heat dissipating plate 300. At this time, the height of the boss 340 may correspond to the height of the first heat dissipating plate 651 configured in the power converting module unit 600. That is, the boss 340 has a function that supports and fixes the power converting module unit 600 placed on the second heat dissipating plate 300, and separates the substrate configuring the power converting module unit 600 from the upper surface of the second heat dissipating plate 300 at a predetermined distance such that the electronic component 800 and the substrate are not in contact with each other.

In addition, a sealing member 230 for blocking foreign matter that permeates between the lower case 220 and the second heat dissipating plate 300 is disposed in a coupling region between the lower case 220 and the second heat dissipating plate 300. Preferably, the sealing member 230 may be a waterproof ring that prevents moisture from penetrating between the lower case 220 and the second heat dissipating plate 300.

Hereinafter, the circuit breaker module unit 400 will be described in detail.

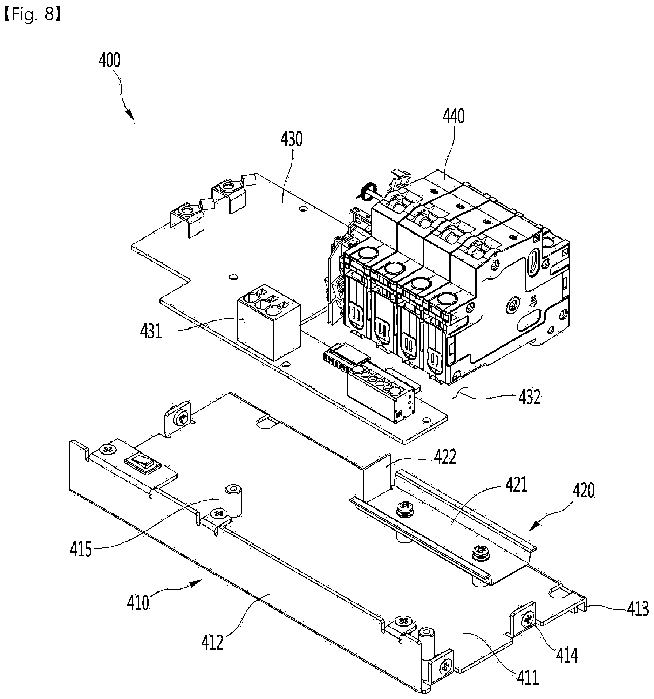

FIG. 8 is a view specifically showing the circuit breaker module unit 400 shown in FIG. 3.

Referring to FIG. 8, the circuit breaker module unit 400 includes a frame 410, a bracket 420, a substrate 430, and a breaker 440.

The frame 410 has an "L" shape. That is, the frame 410 includes a lower plate portion 411 and a left plate portion 412 extending in a vertical direction from one end of a left side of the lower plate portion 411. The lower plate portion 411 of the frame 410 is a placing portion on which the substrate 430 and the breaker 440 configuring the circuit breaker module unit 400 are placed. Further, the lower plate portion 411 protects the substrate 430 and a lower region of the breaker 440 placed on the frame 410.

The frame 410 positions stably the substrate 430, and serves as an electro magnetic interference (EMI) shield and ground accordingly.

The left plate portion 412 protects left regions of the substrate 430 and the breaker 440 that are placed on the frame 410.

That is, the circuit breaker module unit 400 is not disposed in the upper region of the lower case 220, and is disposed protruding to a left region of the lower case 220 as a right end of the lower plate portion 411 of the frame 410 is fastened to the left end of the lower case 220.

Accordingly, a lower region of the circuit breaker module unit 400 is not protected by the lower case 220. Therefore, the lower plate portion 411 is coupled to the left end of the lower case 220 to provide a placing space such that the substrate 430 and the breaker 440 are placed, and to protect the lower regions of the substrate 430 and the breaker 440.

In addition, the upper case 210 has an opened left side surface as described above. Therefore, the left plate portion 412 of the frame 410 covers the opened left side surface. Further, the front and rear of the substrate 430 and breaker 440 placed on the frame 410 are covered by a side plate 215 of the upper case 210, and upper portions of the substrate 430 and the circuit breaker 440 are covered by a first upper plate 211 of the upper case 210.

Meanwhile, a fastening portion (not shown) bent in the right direction at an upper end thereof is formed at the left plate portion 412, which may be coupled to the first upper plate 211 of the upper case via a separate fastening member.

In addition, the lower plate portion 411 may be formed with a fastening portion 414 that extends vertically upward from a front end of the lower plate portion 411 and is coupled to the first upper plate 211 of the upper case 210 accordingly.

Further, the lower plate portion 411 may be further formed with a fastening portion 413 that extends vertically downward from the right end of the lower plate portion 411 and is fitted and coupled to the lower case 220 accordingly.

Furthermore, an upper surface of the lower plate portion 411 may be further formed with a fixing portion 415 that protrudes from the upper surface of the lower plate portion 411 and fixes the substrate 430 disposed at the upper portion thereof.

Meanwhile, a bracket 420 is disposed on the lower plate portion 411. The bracket 420 includes a lower plate bracket portion 421 and a stepped portion 422 protruding vertically upward from at least one end portion of the lower plate bracket portion 421. The bracket 420 fixes the breaker 440 disposed at the upper portion thereof. The circuit breaker 440 may be placed on the lower plate bracket portion 421 of the bracket portion 420, and may be fitted and fixed to the stepped portion 422 accordingly.

A substrate 430 is coupled onto the lower plate portion 411 of the frame 510. Each of circuit components configuring the circuit breaker module unit 400 are mounted on the substrate 430, and a circuit pattern (not shown) for electrically connecting the circuit components to each other is disposed thereon.

The substrate 430 may be rigid or flexible. For example, the substrate 430 may include glass or plastic. Specifically, the substrate 430 may include chemically tempered/semi-tempered glass such as soda lime glass, or aluminosilicate glass, etc., a tempered or flexible plastic such as polyimide (PI), polyethylene terephthalate (PET), propylene glycol (PPG), polycarbonate (PC), etc., or sapphire.

In addition, the substrate 430 may include an optically isotropic film. As an example, the substrate 110 may include cyclic olefin copolymer (COC), cyclic olefin polymer (COP), optically isotropic polycarbonate (PC), optically isotropic polymethylmethacrylate (PMMA), or the like.

Meanwhile, a signal IO port 431 connected to an external device for interfacing with the external device is disposed on the substrate 430. The signal IO port 431 is disposed in a region corresponding to an interface exposure hole 2111 of the upper case 210 disposed at the upper portion, and a terminal (not shown) configuring the signal IO port 431 is exposed to the outside through the interface exposure hole 2111 accordingly.

At this time, the substrate 430 includes an open portion 432 in which a region in which the breaker 440 is disposed is opened in the upper surface of the lower plate portion 411 of the frame 410.

As described above, in the circuit breaker module unit 400, the frame 410, the bracket 420, the substrate 430, and the breaker 440 are configured as one module, and the circuit breaker module unit 400 is coupled to the lower case 220 and the upper case 210 accordingly.

Hereinafter, the battery management module unit 500 will be described in detail.

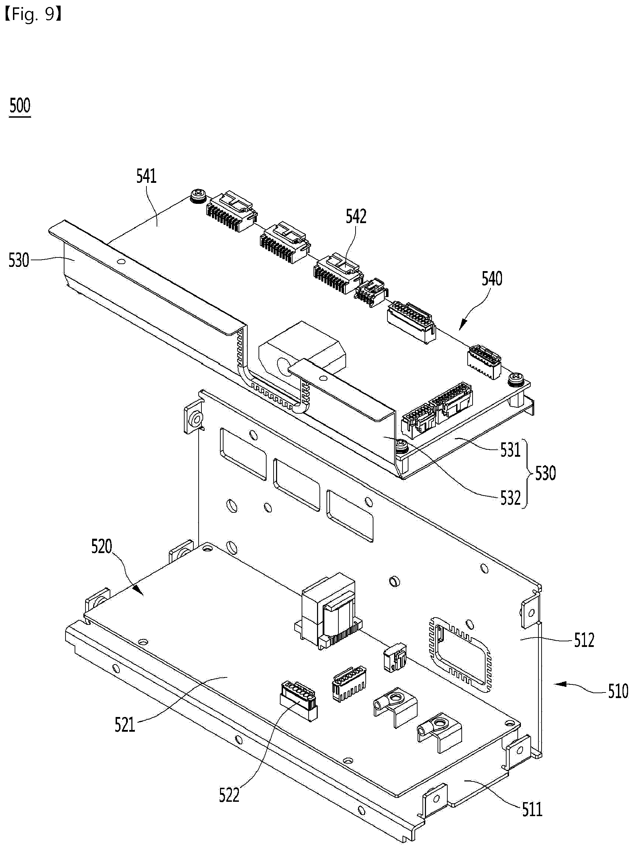

FIG. 9 is a view specifically showing the battery management module unit 500 shown in FIG. 3.

Referring to FIG. 9, the battery management module unit 500 includes a first frame 510, a first substrate 520, a second frame 530, and a second substrate 540.

The first frame 510 includes a lower plate portion 511 and a right plate portion 512 extending in the vertical direction at a right one end of the lower plate portion 511. The lower plate portion 511 of the frame 510 supports the first substrate 520 on which an auxiliary power circuit serving as a branch point of a battery power is mounted among the components configuring the battery management module unit 500.

That is, the first frame 510 is a placing portion on which the first substrate 520 is placed. The lower plate portion 511 protects a lower region of the first substrate 520 that is placed on the first frame 510.

In addition, the right plate portion 512 protects right regions of the first substrate 520 placed on the first frame 510 and the second substrate 540 placed on the second frame 530.

That is, the battery management module unit 500 is not disposed in the upper region of the lower case 220, but is disposed protruding to a right region of the lower case 220 as a left end of the lower plate portion 511 of the first frame 510 is fastened to the right end of the lower case 220. Accordingly, a lower region of the battery management module unit 500 is not protected by the lower case 220. Therefore, the lower plate portion 512 is coupled to the right end of the lower case 220 to provide a placing space such that the first substrate 520 is placed, and to protect a lower region of the first substrate 520.

In addition, the upper case 210 has an opened right side surface as described above. Therefore, the right plate portion 512 of the first frame 510 covers the opened right side surface. Further, the front and rear of the first and second substrates 520 and 540 placed on the first frame 510 are covered by a side plate 215 of the upper case 210, and upper portions of the first and second substrates 520 and 540 are covered by a fourth upper plate 214 of the upper case 210.

Meanwhile, at least one bent portion is formed at the lower plate portion 511 and the right plate portion 512, which may be coupled to the lower case 220 and the upper case 210 by a separate fastening member accordingly.

The first substrate 520 is coupled on the lower plate portion 511 of the first frame 510. A component configuring the auxiliary power circuit is mounted on an upper surface 521 of the first substrate 520. The component includes a branching unit 522 that branches the battery power supply.

The second frame 530 and the second substrate 540 are disposed on the first frame 510. The second frame 530 positions stably the second substrate 540, and serves as an electro magnetic interference (EMI) shield and ground accordingly.

The second frame 530 includes a lower plate portion 531 and a right plate portion 532 bent and extended upward at a right end of the lower plate portion 531.

The lower plate portion 531 is a placing portion on which the second substrate 540 is placed, and is a partition wall portion for blocking signal interference with the power converting module unit 600 disposed on a left side of the battery management module unit 500 in the lower region of the upper case 210.

The second substrate 540 is coupled on the lower plate portion 531 of the second frame 530. A power supply interface unit 542 that is connected to a battery (not shown), receives power supplied from the battery, and transfers the received power to the power converting module unit 600 is disposed on the upper surface 521 of the second substrate 540.

As described above, the battery management module unit 500 is configured as one module of the first frame 510, the second frame 530, the first substrate 520, and the second substrate 540, and is coupled to the lower case 220 and the upper case 210 accordingly.

Hereinafter, the power converting module unit 600 according to an embodiment of the present invention will be described in more detail.

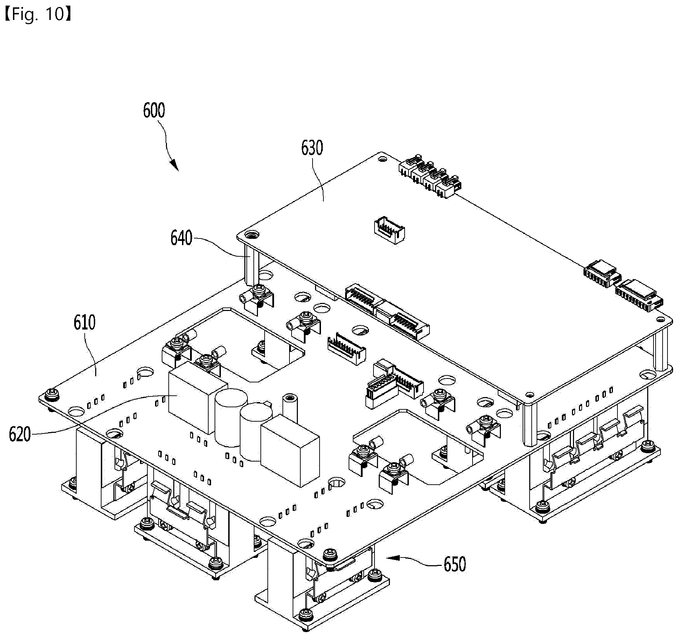

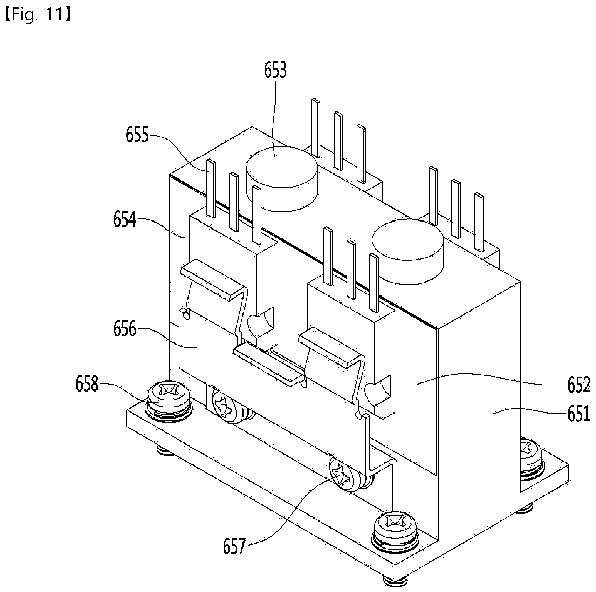

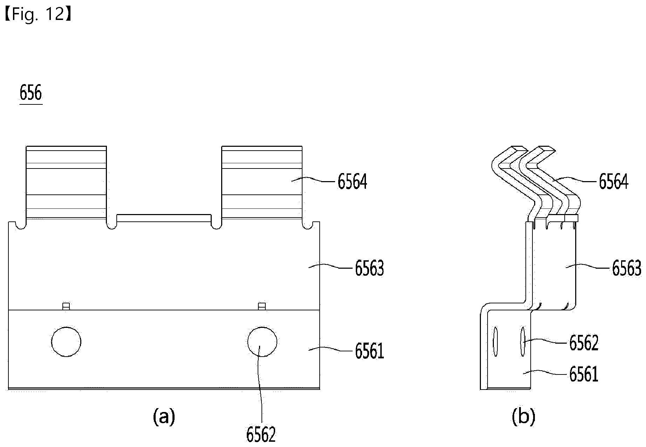

FIG. 10 is a view specifically showing the power converting module unit 600 shown in FIG. 3, FIG. 11 is a view specifically showing a heat dissipating module 650 shown in FIG. 10, and FIG. 12 is a view specifically showing a support member 656 of FIG. 11.

The power converting module unit 600 includes a first substrate 610 on which a power conversion component 620 is mounted, a second substrate 630 on which a control component (not shown) is mounted, a boss 640 that is disposed on the first substrate 610 to support the second substrate 630, and a heat dissipating module 650 that is disposed under the first substrate 610 to dissipate heat of a heating element 654 mounted on the first substrate 610.

The first substrate 610 is a substrate on which various components that perform power conversion operations are mounted. For example, an inductor, a diode, a transformer, and the like may be mounted on the first substrate 610. Preferably, each component configuring a DC-DC converter that receives power supplied from the battery and converts it into DC power required for each configuration is mounted on the first substrate 610. That is, the first substrate 610 is a substrate on which various elements that cause an electrical operation including a heating element 654 to be described later are mounted.

The boss 640 that supports the second substrate 630 disposed on the first substrate 610 is disposed in an edge region of the first substrate 610. That is, the components disposed on the first substrate 610 include high height components. For example, a component such as a transformer has a high height, and is disposed to protrude on the first substrate 610 with a predetermined height accordingly. Therefore, the boss 640 is configured such that the second substrate 630 is disposed on the high height component. That is, the boss 640 is formed in plural around a region in which the second substrate 630 is disposed to support the second substrate 630 disposed on the high height component.

Control components for controlling operations of the power module units 400, 500, and 600 are mounted on the second substrate 630. The control component controls an overall operation of a power converting module 100, and in particular controls a switching operation of switching elements necessary for the power conversion operation.

The heat dissipating module 650 is disposed under the second substrate 620.

Preferably, a heating element 654 configuring the heat dissipating module 650 is mounted on a lower surface of the second substrate 620. That is, the power conversion components include a heating element 654 that generates a lot of heat during operation. Here, representative examples of the heating element 654 include a transformer and a power transistor which is a power device.

In this case, heat generated by the heating element 654 should be effectively cooled to prevent occurrence of fire as well as for an efficient operation of the power converting module. At this time, in the related art, only one main heat sink (the second heat dissipating plate 300 in the present invention) exposed outside the case of the power converting module is used in order to cool the heating element 654, and a lot of problems occurs accordingly.

Therefore, in the present invention, it is possible to prevent direct heat transfer between the heating element 654 and the second heat dissipating plate 300. To this end, in the present invention, the first heat dissipating plate 651 is disposed between the heating element 654 and the second heat dissipating plate 300 such that the heat generated by the heating element 654 is primarily dissipated at the first heat dissipating plate 651, and the primarily dissipated heat is transferred to the second heat dissipating plate 300.

At this time, as shown in FIG. 1, in the related art, the heating element 654 is disposed horizontally on a lower surface of the first substrate 610. However, in the present invention, the heating element 654 is disposed vertically on the lower surface of the first substrate 610. That is, when the heating element 654 is disposed horizontally as in the related art, an area occupied by the heating element 654 on the first substrate 610 increases. However, in the present invention, the heating element 654 is vertically disposed on the first substrate 610, so that the area occupied by the heating element 654 on the first substrate 610 is smaller than that of the related art. And thus, a number of heating elements disposed in the same substrate may be increased, or a size of the substrate on which the same heating element is disposed may be reduced. This is because an area of the surface in which the heating element 654 and the first substrate 610 face each other when the heating element 654 is disposed vertically is smaller than an area when the heating element 654 is disposed horizontally.

Hereinafter, the heat dissipating module 650 will be described in more detail.

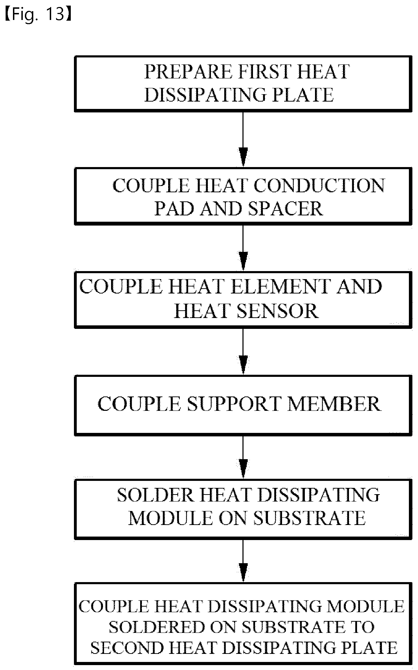

FIG. 11 is a view specifically showing the heat dissipating module 650 shown in FIG. 10, FIG. 12 is a view specifically showing the support member 656 shown in FIG. 11, FIG. 13 is a flowchart step by step showing a method of manufacturing the heat dissipating module 650 shown in FIG. 11, and FIGS.14 to 18 are views showing in process sequence a method of manufacturing the heat dissipating module 650 according to an embodiment of the present invention.

Referring to FIGS. 11 to 18, the heat dissipating module 650 includes a first heat dissipating plate 651, a heat transfer pad 652, a spacer 653, a heating element 654, a support member 656, a first fastening member 657, and a second fastening member 658.

The first heat dissipating plate 651 is coupled to the heating element 654 and the second heat dissipating plate 300. Preferably, a side surface of the first heat dissipating plate 651 is coupled to the heating element 654, and a lower surface thereof is coupled to the second heat dissipating plate 300.

Accordingly, the first heat dissipating plate 651 includes a first portion coupled to the second heat dissipating plate 300 and a second portion 6512 disposed on the first portion 6511 to couple to the heating element 654. At this time, for convenience of description, the first heat dissipating plate 651 is divided into the first portion 6511 and the second portion 6512, but it is preferable that the first portion 6511 and the second portion 6512 are one configuration integrally formed.

The first portion 6511 has a square plate shape. The first portion 6511 has a size corresponding to a first placing portion 350 formed on a base 310 of the second heat dissipating plate 300. That is, a width of the first portion 6511 corresponds to a width of the first placing portion 350. The first portion 6511 is disposed on the first placing portion 350 of the base 310. A lower surface of the first portion 6511 is in surface contact with an upper surface of the base 310.

The second portion 6512 has a square pillar shape on the first portion 6511, and protrudes from an upper surface of the first portion 6511. The second portion 6511 has a width narrower than that of the first portion 6511.

In other words, the first portion 6511 has a square plate shape having a first horizontal width and a first vertical width. Further, the second portion 6512 has a quadrangular prism shape having a second horizontal width that is narrower than the first horizontal width and a second vertical width that is the same as the first vertical width. At this time, in drawings, the first portion 6511 and the second portion 6512 have a square shape, but it is merely one embodiment, and the first portion 6511 and the second portion 6512 may have any one of a circular shape, a triangular shape, and a polygonal shape, in addition to the square shape.

The second portion 6512 is formed to protrude from a central region of the first portion 6511. Accordingly, a central region of an upper surface of the first portion 6512 is in contact with a lower surface of the second portion 6512. Remaining left and right regions excluding the central region of the upper surface of the first portion 6511 are exposed. Accordingly, the first heat dissipating plate 651 including the first portion 6511 and the second portion 6512 may have a "⊥" shape.

A through-hole 6513 passing through the upper surface and lower surface of the first portion 6511 is formed in the left and right regions of the exposed first portion 6511. The second fastening member 658 is inserted into the through-hole 6513. The second fastening member 658 passes through the through-hole 6513 and is inserted into a fastening groove (not shown) of the first placing portion 350, and accordingly the first heat dissipating plate 651 is fixed on the base 310 of the second heat dissipating plate 300.

A left side surface and a right side surface of the second portion 6512 are divided into a first region in which the support member 656 is coupled and a second region in which the heating element 654 is coupled. At this time, one heating element 654 may be coupled to the second region of each of the left side surface and the right side surface of the second portion 6512, and a plurality of heating elements 654 may be disposed at a predetermined distance.

In addition, a first fastening groove 6514 for fastening the spacer 653 is formed on the upper surface of the second portion 6512. Further, a plurality of second fastening grooves 6515 for fastening the support member 656 are formed in the first region of each of the left side surface and the right side surface of the second portion 6512. Furthermore, a plurality of third fastening grooves 6516 for fastening the heating element 654 are formed in the second region of each of the left side surface and the right side surface of the second portion 6512.

The first fastening groove 6514 is formed on the upper surface of the second portion 6512 with a predetermined depth in a thickness direction of the second portion 6512. Further, the second fastening groove 6515 and the third fastening groove 6516 are formed on the left side surface and the right side surface of the second portion 6512 with a predetermined depth in a length direction of the second portion 6512. Meanwhile, inner walls of the first fastening groove 6514, the second fastening groove 6515, and the third fastening groove 6516 may have a screw shape, respectively.

The heat transfer pad 652 is disposed in the second region of the left side surface and the right side surface of the second portion 6512. That is, the heat transfer pad 652 is inserted between the second portion 6512 and the heating element 654. The heat transfer pad 652 is a heat transfer member that thermally connects the heating element 654, the first heat dissipating plate 651, and the second heat dissipating plate 300, and accordingly heat generated by the heating element 654 s transferred to the first heat dissipating plate 651. To this end, the heat transfer pad 652 may be formed of a metal material having excellent thermal conductivity, and may include, for example, a metal material such as silver (Ag), copper (Cu), gold (Au), aluminum (Al), and the like.

At this time, the heat transfer pad 652 is formed with a through-hole 6521 at a position corresponding to the third fastening groove 6516 of the second portion 6512, and accordingly an element fastening member 6544 passes through the through-hole 6521 to be fastened to the third fastening groove 6516.

The heating element 654 includes an element body 6541, a terminal 6542, and a through-hole 6543 that passes through the element body 6541 in the length direction.

The element body 6541 is a component that generates heat during operation, and may be, for example, a power transistor. The terminal 6542 protrudes from the element body 6541 and is electrically connected to the first substrate 610 accordingly. At this time, the terminal 6542 may pass through the first substrate 610, and may be fixed and coupled to the first substrate 610 by an adhesive paste such as solder.

The terminal 6542 electrically connects the element body 6541 and a circuit pattern (not shown) formed on the first substrate 610. The through-hole 6543 passes through the element body 6541. Preferably, the through-hole 6553 passes through a left side surface and a right side surface of the element body 6541 in a vertically standing state. Accordingly, the element body 6541 is coupled to the second portion 6512 of the first heat dissipating plate 651 in the vertically standing state.

In addition, the element fastening member 6544 passes through the through-hole 6553 of the heating element 654 and the through-hole 6521 of the heat transfer pad 652, and is inserted into the third fastening groove 6516 of the second portion 6512.

The spacer 653 is disposed on the upper surface of the second portion 6512. The spacer 653 includes a body 6531 and a fastening protrusion 6532. The fastening protrusion 6532 is inserted into the first fastening groove 6514, and the body 6531 protrudes on the upper surface of the second portion 6512 accordingly.

The spacer 653 is disposed on the second portion 6512 so that the first heat dissipating plate 651 and the first substrate 610 do not contact each other. That is, the spacer 653 separates the upper surface of the second portion 6512 of the first heat dissipating plate 651 from the lower surface of the first substrate 610 at a predetermined distance.

In addition, the spacer 653 adjusts flatness between the first heat dissipating plate 651 and the first substrate 610, and accordingly, it is possible to minimize stress that may occur due to a height difference of the heating element 654 by a problem of the flatness.

One end of the support member 656 is coupled to the second portion 6512 of the first heat dissipating plate 651, and the other end contacts the element body 6541 of the heating element 654. The support member 656 has an elastic force, and accordingly, causes the element body 6541 of the heating element 654 to adhere to the heat dissipating pad 652. That is, the support member 656 secures a separation distance between a positive pole of the heating element 654 and a negative pole of the ground, and simultaneously applies pressure to the element body 6541 in order to enhance the transfer of heat generated by the heating element 654.

To this end, the support member 656 may be formed of a metal material such as stainless steel in order to ensure a predetermined level of elastic force.

A through-hole 6562 is formed at the support member 656. The through-hole 6562 is formed at a position corresponding to the second fastening groove 6515 formed in the second portion 6512. The first fastening member 657 passes through the through-hole 6562 formed in the support member 656 and is inserted into the second fastening groove 6515.

More specifically, the shape of the support member 656 is as follows.

The support member 656 is coupled to the second portion 6512, and includes a first region 6561 in which the through-hole 6562 is formed, a second region 6563 bent from the first region 6561 in a first direction, and a third region 6564 bent from the second region 6563 in a second direction opposite to the first direction.

The through-hole 6562 is formed in the first region 6561. The first region 6561 is in contact with the second portion 6512 of the first heat dissipating plate 651. The first heat dissipating plate 651 is fastened by the first fastening member 657.

The second region 6563 is bent in the first direction from the first region 6561. The second region 6563 is bent in a direction opposite to the bending direction of the third region 6564 so as to increase the pressure applied to the heating element 654 through the third region 6564. The second region 6563 is not in contact with the first heat dissipating plate 651. Here, the first direction may be a direction opposite to a direction in which the first heat dissipating plate 651 is disposed. In other words, when the support member 656 is disposed on the right side surface of the second portion 6513, the second region 6563 is bent in the right direction instead of the left direction in which the first heat dissipating plate 651 is disposed.

The third region 6564 is bent from the second region 6563 in a second direction opposite to the bending direction of the second region 6563. That is, when the second region 6563 is bent in the right direction as described above, the third region 6564 is bent in the left direction from an end of the second region 6563.

The third region 6564 contacts the element body 6541, and applies a predetermined level of pressure to the element body 6541 accordingly. At this time, a portion in contact with the element body 6541 has a predetermined curvature so that the element body 6541 is not damaged by the applied pressure.

Meanwhile, the third region 6564 is formed by branching in plural from the second region 6563. That is, the third region 6564 includes a plurality of branch portions that branch to be spaced apart from the second region 6563 at a predetermined distance. For example, when the first and second heating elements are respectively coupled to the left side surface of the second portion 6512, the third region 6564 branches from the second region 6563, and may include a first branch portion that contacts the first heating element and a second branch portion that is spaced apart from the first branch portion at a predetermined distance and branches from the second region 6563 to contact the second heating element.

That is, in the present invention, when a plurality of heating elements are disposed on one side surface of the second portion as described above, the third region 6564 of the support member 656 is branched in plural such that different pressures may be applied to each of the heating elements.

Hereinafter, a manufacturing method (assembly method) of the heat dissipating module 650 as described above will be described in detail.

Referring to FIG. 13, first, a first heat dissipating plate 651 including the first portion 6511 and the second portion 6512 as described above is prepared (step 110).

When the first heat dissipating plate 651 is prepared, a spacer 653 is coupled to the upper surface of the second portion 6512 of the first heat dissipating plate 651, and a heat dissipating pad 652 is coupled to the left side surface and the right side surface of the second portion 6512 (step 120).

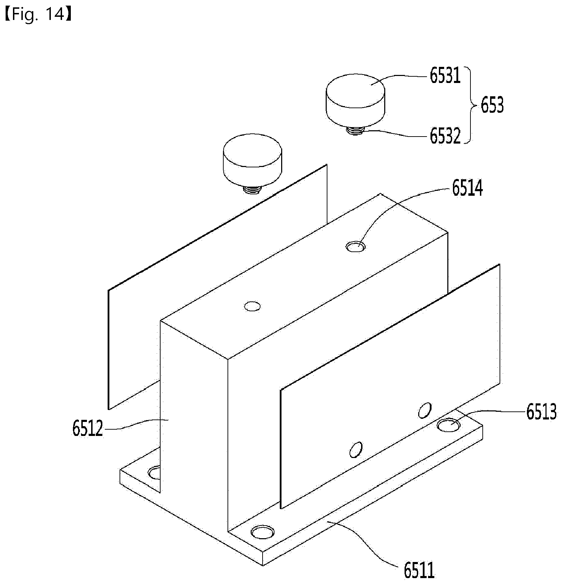

That is, as shown in FIG. 14, the first fastening groove 6514 is formed on the upper surface of the second portion 6512, and the third fastening groove 6516 is formed on the left side surface and the right side surface. Accordingly, the protrusion 6532 of the spacer 653 is inserted into the first fastening groove 6514, and the spacer 653 is disposed on the upper surface of the second portion 6512. And then, the heat dissipating pad 652 is fixed in a state in which the third fastening groove 6516 and the through-hole 6521 of the heat dissipating pad 652 are aligned with each other. At this time, the heat dissipating pad 652 is coupled to the first heat dissipating plate 651 through an element body 6541 and an element fastening member 6544 of the heating element 654 later. Accordingly, an adhesive material is formed on one side of the heat dissipating pad 652 such that the heat dissipating pad 652 is disposed at a designated position until the heating element 654 is coupled, and the heat dissipating pad 652 is attached to the left side surface and the right side surface of the second portion 6512, respectively.

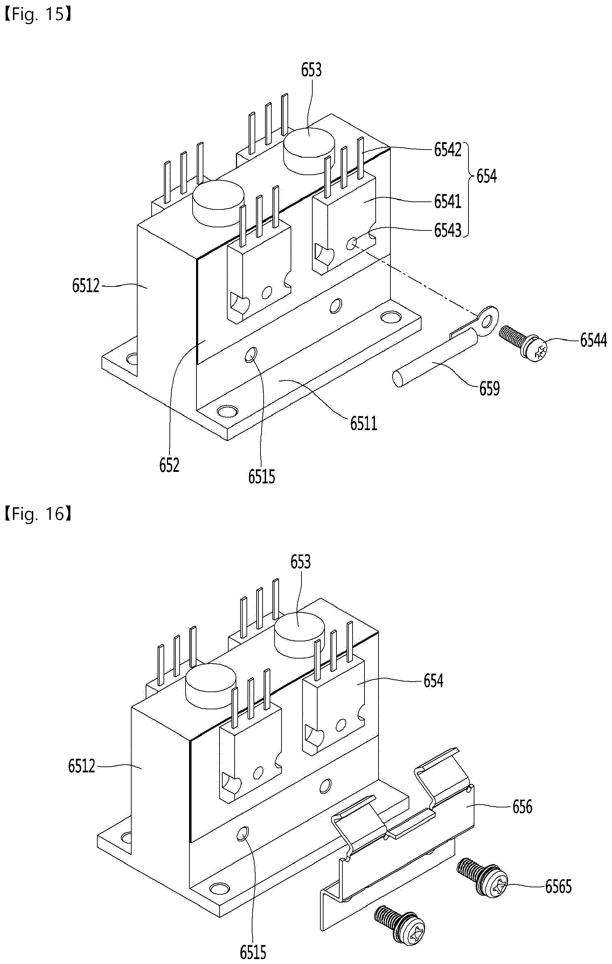

Thereafter, the heating element 654 and a heat sensor 659 are coupled to the second portion 6512 of the first heat dissipating plate 651 (step 130). That is, as shown in FIG. 15, the element fastening member 6514 is inserted into the first fastening groove 6514 through the through-hole 6543 of the element body 6541 and the through-hole 6521 of the heat dissipating pad 652, and thus the heating element 654 may be coupled to the first heat dissipating plate 651.

In addition, a heat sensor 659 may be further coupled to the first heat dissipating plate 651. The heat sensor 659 measures a temperature of the first heat dissipating plate 651 in order to confirm whether the power converting module unit 600 is stably operated, and transmits the measured temperature to a control component disposed on the second substrate 630 accordingly.

Thereafter, the support member 656 is coupled to the first heat dissipating plate 651 (step 140). That is, as shown in FIG. 16, a through-hole 6562 formed in the first region 6561 of the support member 656 and a second fastening groove 6515 formed in the second portion 6512 of the first heat dissipating plate 651 are arranged, and the support member 656 is coupled to the first heat dissipating plate 651 such that the first fastening member 657 passes through the through-hole 6562 and is inserted into the second fastening groove 6515 accordingly. When the support member 656 is coupled, each branch portion of the third region 6564 configuring the support member 656 is in contact with the heating element 654, and pressure is applied to the heating element 654 by the elastic force generated by the support member 656 accordingly.

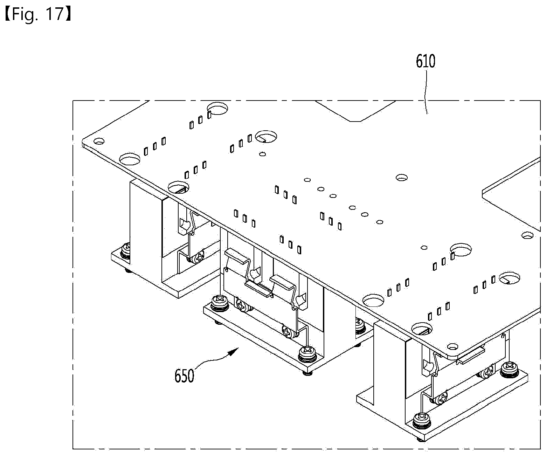

Next, when the heat dissipating module 650 as described above is manufactured, the manufactured heat dissipating module 650 and the first substrate 610 are coupled (step 150). That is, as shown in FIG. 17, a mounting position of the heating element 654 coupled to the heat dissipating module 650 of the lower surface of the first substrate 610 is confirmed, and soldering of the terminal 6542 of the heating element 654 on the circuit pattern of the first substrate 610 is performed at the confirmed mounting position.

At this time, a separate guide jig (not shown) may be used for confirming the mounting position of the heating element 654 and fixing the heat dissipating module 650 at the mounting position.

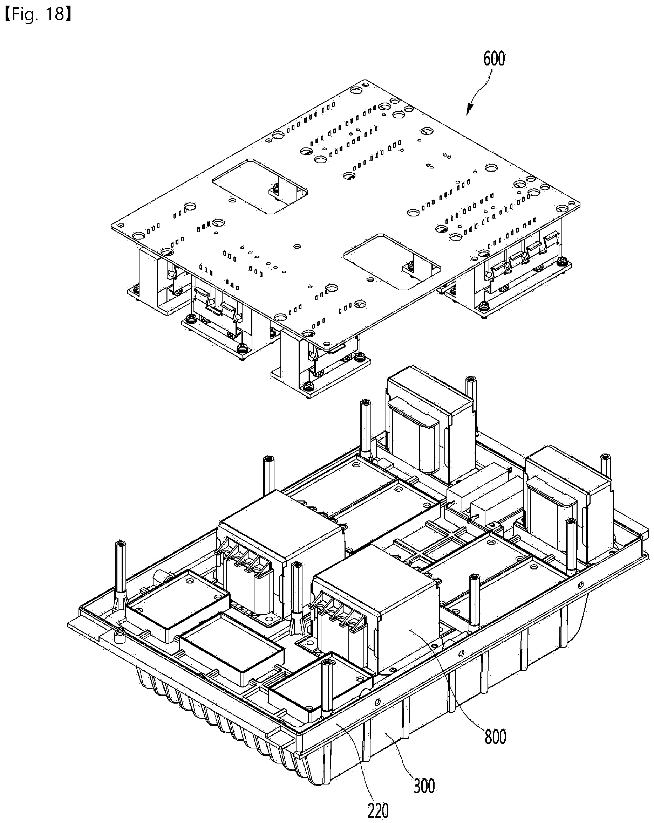

Next, the power converting module unit 600 manufactured as described above is coupled to the first placing portion 350 of the base 610 of the second heat dissipating plate 300 (step 160). That is, as shown in FIG. 18, after the first portion 6511 of the first heat dissipating plate 651 is positioned on the first placing portion 350, the first heat dissipating plate 651 and the second heat dissipating plate 300 are coupled to each other via a separate fastening member. At this time, in order to increase the thermal conductivity between the first heat dissipating plate 651 and the second heat dissipating plate 300, a thermal grease 900 is applied on the first placing portion 350, and the first heat dissipating plate 651 may be coupled on the applied thermal grease 900.

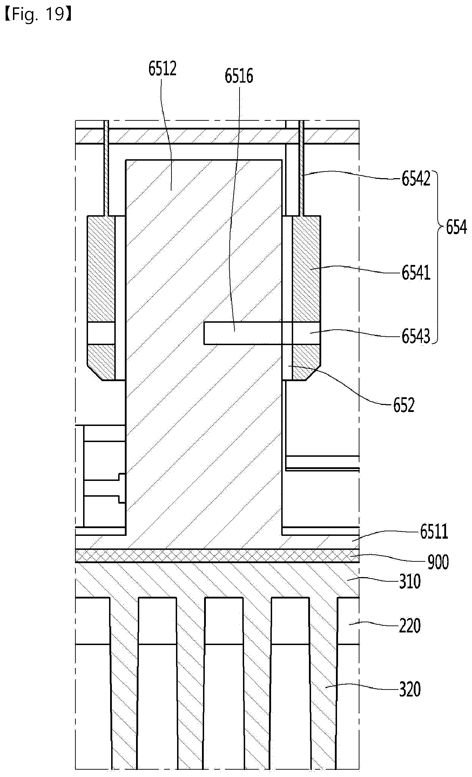

FIG. 19 is a view for describing a heat dissipation mechanism according to an embodiment of the present invention.

Referring to FIG. 19, the embodiment of the present invention includes a heat dissipating module 650 having the above structure. Accordingly, the heat dissipation mechanism may be largely divided into three steps.

In the first step, heat conduction occurs between the heating element 654 that generates heat and the first heat dissipating plate 651. At this time, in order to enhance the heat conduction efficiency between the first heat dissipating plate 651 and the heating element 654, the heat dissipating pad 652 as described above is disposed between the first heat dissipating plate 651 and the heating element 654 to maximize a heat dissipating area.

In the second step, the heat conducted to the first heat dissipating plate 651 from the heating element 654 is primarily dissipated at the first heat dissipating plate 651. And then, the heat dissipated primarily is transmitted to the second heat dissipating plate 300 via the thermal grease 900. At this time, in order to minimize the thermal resistance between the first heat dissipating plate 651 and the second heat dissipating plate 300, the thermal grease 900 as described above is applied to an upper surface of the first placing portion 350.

At this time, the first heat dissipating plate 651 and the second heat dissipating plate 300 may use an aluminum alloy having high thermal conductivity and a low specific gravity, but since the aluminum alloy is an alloy for die casting, the thermal conductivity thereof is slightly inferior to the thermal conductivity of pure aluminum originally possessed. In order to compensate for this, in the present invention, the thermal grease 900 having higher thermal conductivity than the heat dissipating pad 652 and capable of maximizing a heat conduction area is applied.

In the third step, the heat transferred to the second heat dissipating plate 300 is transferred to the heat dissipating fin 320 via the base 310 of the second heat dissipating plate 300, and finally transferred to the outside of the housing. At this time, not only one heat dissipating module is disposed on the upper part of the base 310, but a plurality of heat dissipating modules are disposed on a plurality of placing portions, and thus the heat dissipating fin 320 has a fin structure that extends long in a length direction and spaced apart at a predetermined distance. At this time, since the heat dissipating fin 320 is exposed outside the housing, it is preferable that powder coating is applied in order to prevent corrosion or erosion and to solve a problem of low thermal emissivity (phenomenon due to heat reflection) on the surface, which is a characteristic of metal.

According to an embodiment of the present invention, heat transferred via a heating element is primarily dissipated by using a separate sub-heat dissipating plate, and the heat dissipated primarily is transferred to a main heat dissipating plate to be released to the outside, and thus heat transferred to the main heat dissipating plate may be minimized. Accordingly, it is possible to solve safety problems that may occur as a temperature of the main heat dissipating plate exposed to the outside increases.

In addition, according to an embodiment of the present invention, an area occupied by the heating element on the substrate may be reduced by mounting the heating element vertically on the substrate, and accordingly the overall size of a power converting module may be reduced.

In addition, according to an embodiment of the present invention, assembly processes of a plurality of heat dissipating components may be simplified by manufacturing and assembling the plurality of heat dissipating components in a modular type, and accordingly an arrangement space for heat dissipating components may be optimized.

The characteristics, structures and effects described in the embodiments above are included in at least one embodiment but are not limited to one embodiment. Furthermore, the characteristic, structure, and effect illustrated in each embodiment may be combined or modified for other embodiments by a person skilled in the art. Thus, it should be construed that contents related to such a combination and such a modification are included in the scope of the present invention.

Embodiments are mostly described above. However, they are only examples and do not limit the present invention. A person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the present invention defined in the following claims.

## Claims

1. A heat dissipating device of a power converting module, the heat dissipating device comprising:
a housing;
a substrate disposed inside the housing;
a heating element disposed inside the housing and connected to the substrate;
a first heat dissipating plate disposed inside the housing and coupled to the heating element; and
a second heat dissipating plate disposed at a lower portion of the first heat dissipating plate,
wherein the heating element is coupled to a side surface of the first heat dissipating plate, and
wherein the first heat dissipating plate is disposed between the substrate and the second heat dissipating plate.

2. The heat dissipating device of claim 1, wherein the side surface of the first heat dissipating plate to which the heating element is coupled is perpendicular to the substrate.

3. The heat dissipating device of claim 1, wherein the heating element is vertically disposed at a lower portion of the substrate to be coupled to the side surface of the first heat dissipating plate.

4. The heat dissipating device of claim 1, wherein the heating element includes a fastening hole, and
the first heat dissipating plate includes a first fastening groove, and further includes a fastening member that passes through the fastening hole to be inserted into the first fastening groove.

5. The heat dissipating device of claim 1, further comprising
a spacer disposed between the first heat dissipating plate and the substrate.

6. The heat dissipating device of claim 1, further comprising
a support member that is coupled to the first heat dissipating plate to support the heating element.

7. The heat dissipating device of claim 6, wherein the support member includes a first support region that is coupled to the first heat dissipating plate and includes a through-hole, a second support region that is bent in a first direction from the first region, and a third support region bent from the second region in a second direction opposite to the first direction and contacts the heating element.

8. The heat dissipating device of claim 7, wherein the third region of the support member has a predetermined curvature at a portion in contact with the heating element.

9. The heat dissipating device of claim 6, wherein the third support region includes a plurality of branch portions spaced apart from the second support region at a predetermined distance.

10. A power converting module comprising:
a housing having an accommodating space inside thereof, and including a plurality of through-holes spaced apart from each other at a predetermined distance at a lower portion thereof;
a power module unit accommodated in the accommodating space of the housing, and including a first heat dissipating plate; and
a second heat dissipating plate coupled to the power module unit, and at least partially exposed to the outside through the plurality of through-holes of the housing,
wherein the power module unit includes:
a substrate disposed inside the housing;
a heating element disposed inside the housing, and connected to the substrate; and
the first heat dissipating plate disposed inside the housing, and coupled to the heating element,
wherein the heating element is coupled to a side surface of the first heat dissipating plate, and
wherein the first heat dissipating plate is disposed between the substrate and the second heat dissipating plate.
